# EUROPEAN PATENT APPLICATION

(11) **EP 4 571 332 A1**
(43) Date of publication of application: **18.06.2025**
(21) Application number: 22960329.5
(22) Date of filing: 30.09.2022
(51) Int. Cl.: G01R 31/36

(54) **BATTERY CODING METHOD AND APPARATUS, ELECTRONIC DEVICE, AND BATTERY**

(71) Applicant: Contemporary Amperex Technology (Hong Kong) Limited, Hong Kong (HK)
(72) Inventor: ZHOU, Fangjie, Ningde, Fujian 352100 (CN); WANG, Xingchang, Ningde, Fujian 352100 (CN); LI, Qiandeng, Ningde, Fujian 352100 (CN)
(74) Representative: Ziebig Hengelhaupt Intellectual Property Attorneys Patentanwaltskanzlei PartGmbB
(86) International application number: PCT/CN2022/123356
(87) International publication number: WO 2024/065710

(57) **Abstract**

This application provides a battery encoding method and apparatus, an electronic device, and a battery. The method includes: obtaining location information of a battery cell in a battery; obtaining chip identification information of a functional chip of the battery cell; and storing information on a correspondence between the location information of the battery cell and the chip identification information into a battery management unit of the battery. The chip identification information is used for implementing a communication function between the battery management unit and the functional chip.

## Description

### TECHNICAL FIELD

This application relates to the technical field of batteries, and in particular, to a battery encoding method and apparatus, an electronic device, and a battery.

### BACKGROUND

A battery is typically formed by assembling a plurality of battery cells. In order to better manage the battery, a battery management unit (Battery Manage Unit, BMU) is typically configured. The battery management unit is a main controller for the entire battery management. To better manage the battery, the battery management unit usually needs to monitor each battery cell in the battery and obtain the operating parameters of each battery cell.

Currently, the battery management unit is typically connected by wire to a collector that collects the data of each battery cell, so as to obtain the parameters collected by the collector. However, if each collector collects the parameters of one battery cell, a large number of wires need to be laid in the battery, thereby making the factory wiring operations complicated and inefficient. If a collector is in a one-to-many relation with the battery cells, the battery management unit may be inconvenient in communicating with each battery cell, and may be inaccurate in managing each battery cell.

### SUMMARY

In view of this, an objective of some embodiments of this application is to provide a battery encoding method and apparatus, an electronic device, and a battery to alleviate the communication inconvenience between the battery management unit and each battery cell of the battery in the prior art.

According to a first aspect, an embodiment of this application provides a battery encoding method. The method includes: obtaining location information of a battery cell in a battery; obtaining chip identification information of a functional chip of the battery cell; and storing information on a correspondence between the location information of the battery cell and the chip identification information into a battery management unit of the battery. The chip identification information is used for implementing a communication function between the battery management unit and the functional chip.

In an optional embodiment, the obtaining location information of a battery cell in a battery includes: obtaining the location information of the battery cell in the battery based on a preset sequence.

In an optional embodiment, the obtaining location information of a battery cell in a battery includes: obtaining the location information of the battery cell in the battery sequentially based on an arrangement manner of the battery cell in the battery.

In the above embodiment, in collecting the chip identification information of the battery cell, the chip identification information may be collected sequentially, and then the location of the battery cell in the battery can be determined based on the collection sequence, thereby reducing the difficulty of identifying the location of the battery cell, increasing the difficulty of marking the location sequence of each battery cell, and improving the efficiency of marking the location of the battery cell.

In an optional embodiment, the obtaining chip identification information of a functional chip of the battery cell includes: obtaining the chip identification information of the functional chip of the battery cell based on the location information of the battery cell.

In an optional embodiment, the battery includes a plurality of battery modules. Each battery module includes a plurality of battery cells. The location information of the battery cell includes second location information and first location information. The second location information is location information that indicates a location of the battery module containing the battery cell in the battery, and the first location information is location information that indicates a location of the battery cell in the battery module.

The obtaining the chip identification information of the functional chip of the battery cell based on the location information of the battery cell includes: obtaining the chip identification information of each battery cell in the battery module sequentially based on the first location information of the battery cell; generating a module identifier based on the chip identification information of the battery cell in the battery module and the first location information of the battery cell; and obtaining the module identifier of each battery module sequentially based on the second location information of the battery module in the battery.

The storing information on a correspondence between the location information of the battery cell and the chip identification information into a battery management unit of the battery includes:
determining the information on the correspondence between the location information of the battery cell and the chip identification information based on the second location information and the module identification; and
storing the information on the correspondence between the location information of the battery cell and the chip identification information into the battery management unit of the battery.

In the above embodiment, if the battery includes a plurality of battery modules, an intermediate identifier, that is, a module identifier, may be formed first, thereby reducing the complexity of the location information, making the relative position of each battery cell clearer, and in turn, improving the accuracy of the location relation between the battery cells conveyed by the correspondence information.

In an optional embodiment, the obtaining the chip identification information of each battery cell in the battery module sequentially based on the first location information of the battery cell includes: scanning the chip identification information of each battery cell in the battery module sequentially based on the first location information of the battery cell by use of a scanning device after the battery module is assembled.

The obtaining the module identifier of each battery module sequentially based on the second location information of the battery module in the battery includes: scanning the module identifier of each battery module sequentially based on the second location information of the battery module in the battery by use of the scanning device after the battery modules are assembled to form the battery.

In the above embodiment, in assembling the battery, the mounting sequence of each battery cell and the mounting sequence of the battery module can be recorded by a scanning device, thereby reducing the encoding action required after formation of the battery, and improving the efficiency of encoding the battery cells in the battery.

In an optional embodiment, the obtaining location information of a battery cell in a battery includes: obtaining the first location information of the battery cell in the battery module sequentially based on an arrangement manner of the battery cell in the battery module after the battery module is assembled; and obtaining the second location information of the battery module in the battery sequentially based on an arrangement manner of the battery module in the battery after the battery is assembled.

In an optional embodiment, the information on the correspondence further includes cell identification information.

The method further includes: obtaining the cell identification information and the chip identification information of each battery cell after each battery cell is manufactured, and storing the cell identification information in association with the chip identification information of each battery cell.

The storing information on a correspondence between the location information of the battery cell and the chip identification information into a battery management unit of the battery includes: storing information on a correspondence between the location information of the battery cell, the chip identification information, and the cell identification information into the battery management unit of the battery.

In the above embodiment, the cell identification information of each battery cell can be bound to the chip identification information, thereby making it more convenient to obtain various parameters of each battery cell, providing more favorable fundamental data for the maintenance of the battery cell, and in turn, improving the safety and lifespan of the battery.

According to a second aspect, an embodiment of this application provides a battery encoding apparatus, including:
a first obtaining module, configured to obtain location information of a battery cell in a battery;
a second obtaining module, configured to obtain chip identification information of a functional chip of the battery cell; and
a storage module, configured to store information on a correspondence between the location information of the battery cell and the chip identification information into a battery management unit of the battery, where the chip identification information is used for implementing a communication function between the battery management unit and the functional chip.

According to a third aspect, an embodiment of this application provides an electronic device. The electronic device includes: a processor and a memory. The memory stores a machine-readable instruction executable by the processor. When executed by the processor during operation of the electronic device, the machine-readable instruction performs steps of the method described above.

According to a fourth aspect, an embodiment of this application provides a computer-readable storage medium. The computer-readable storage medium stores a computer program. When executed by the processor, the computer program performs steps of the method described above.

According to a fifth aspect, an embodiment of this application provides a battery. The battery includes: a battery management unit, a plurality of battery cells, and a cell monitoring unit mounted on each battery cell.

The battery management unit records chip identification information of each battery cell and location information of each battery cell.

The cell monitoring unit stores the chip identification information of each battery cell and the location information of each battery cell.

In an optional embodiment, a plurality of battery cells form a plurality of battery modules.

A module identifier is set for each battery module.

The module identifier keeps a record of the chip identification information of each battery cell in the battery module and first location information of each battery cell in the battery module.

The battery management unit records second location information of each battery module in the battery.

According to a sixth aspect, an embodiment of this application provides an electrical device. The electrical device includes the battery. The battery is configured to provide electrical energy.

In the battery encoding method and apparatus, the electronic device, and the battery according to some embodiments of this application, the location information of the battery cell in the battery and the chip identification information of the functional chip of the battery cell can be obtained, and then the information on the correspondence between the location information and the chip identification information can be created. The correspondence information is stored in the battery management unit of the battery, thereby creating a relationship between the battery management unit of the battery and each battery cell, and in turn, facilitating one-to-one communication between the battery management unit of the battery and the chip of each battery cell based on the chip identification information.

To make the objectives, features, and advantages of this application clearer and easily comprehensible, the following gives a detailed description of embodiments with reference to accompanying drawings.

### BRIEF DESCRIPTION OF DRAWINGS

To describe technical solutions in embodiments of this application more clearly, the following outlines the drawings to be used in the embodiments. Understandably, the following drawings show merely some embodiments of this application, and therefore, are not intended to limit the scope. A person of ordinary skill in the art may derive other related drawings from the drawings without making any creative efforts.
FIG. 1 is a schematic structural diagram of a battery according to an embodiment of this application;
FIG. 2 is a schematic diagram of interaction between an upper-level controller and a scanning device according to an embodiment of this application;
FIG. 3 is a schematic block diagram of an electronic device according to an embodiment of this application;
FIG. 4 is a flowchart of a battery encoding method according to an embodiment of this application;
FIG. 5 is an optional flowchart of a step 420 in a battery encoding method according to an embodiment of this application; and
FIG. 6 is a schematic diagram of functional modules of a battery encoding apparatus according to an embodiment of this application.

List of reference numerals: 100-battery; 110-battery management unit; 120-battery cell; 130-cell monitoring unit; 140-box; 210-upper-level controller; 220-scanning device; 300-electronic device; 311-memory; 313-processor.

### DETAILED DESCRIPTION OF EMBODIMENTS

The following describes technical solutions in embodiments of this application with reference to the drawings in the embodiments of this application.

It is hereby noted that similar reference numerals and letters indicate similar items in the following drawings. Therefore, once an item is defined in one drawing, the item does not need to be further defined or construed in subsequent drawings. In addition, in the description of this application, the terms "first", "second", and so on are merely intended for ease of differentiation, but not intended to indicate or imply order of precedence.

To better manage the battery, the operating parameters of each battery cell in a battery, such as the temperature, current, and voltage of the battery cell need to be obtained from time to time, so as to manage the battery and monitor the battery safety more efficiently.

Through research, the inventor hereof has learned that battery cells in a battery are currently managed by disposing a sensors at different locations in the battery in advance. The sensors collect the operating parameters of several battery cells disposed around. Subsequently, each sensor may be connected to a battery management unit of the battery, so that the battery management unit can obtain the data collected by the sensor. Generally, if the number of sensors arranged in the battery is relatively small, the wires required to be connected between the sensor and the battery management unit are relatively simple, and the operation is relatively easy. However, this inevitably leads to inability to accurately locate each battery cell. If a relatively large number of sensors are arranged in the battery, for example, if one or more sensors are arranged for each battery cell, the data collected by the sensors can correspond to the battery cells more exactly, and each battery cell can be located accurately. However, this inevitably leads to relatively complicated wires connected between the sensor and the battery management unit, the factory wiring operations are complicated, and the wiring efficiency is low.

Based on the above analysis, this application provides a battery encoding method and apparatus, an electronic device, and a battery, and can implement one-to-one communication between the battery management unit and the chip of each battery cell by associating the chip identification information corresponding to each battery cell with the location of each battery cell and storing the correspondence information into a battery management unit of the battery, without requiring much wiring in the battery. The following describes a battery encoding method and apparatus, an electronic device, and a battery according to some embodiments of this application.

First, some terms used in some embodiments of this application are interpreted below:
Intelligent battery cell: iCell for short, a battery cell in which a cell monitoring unit (Cell Monitor Unit, CMU) is integrated;
Cell monitoring unit: CMU for short, in which a dedicated chip is integrated, where the dedicated chip integrates the functions such as analog front-end (analog front-end, AFE), microcontroller unit (Microcontroller Unit, MCU), and radio frequency communication (Radio Frequency, RF);
Radio management unit (Radio Manage Unit, RMU): configured to manage the entire wireless network, communicate with the CMUs of all intelligent battery cells, receive voltage and temperature data collected by all the CMUs, and send corresponding control instructions of a host MCU;
Host MCU (Host_MCU): configured to control the communication between the RMU and the CMU, implement data processing and analysis, and output control instructions;
Battery management unit (Battery Manage Unit, BMU): a main controller for the entire battery management;
Battery module: a power supply unit that may include a plurality of intelligent battery cells;
Battery: a power supply unit that may include a plurality of intelligent battery cells or a plurality of battery modules.

The battery and battery cell disclosed in some embodiments of this application are applicable to, but not limited to use in, electrical devices such as a vehicle, watercraft, or aircraft. A power supply system of the electrical devices may contain the battery cell, the battery, and the like disclosed in this application.

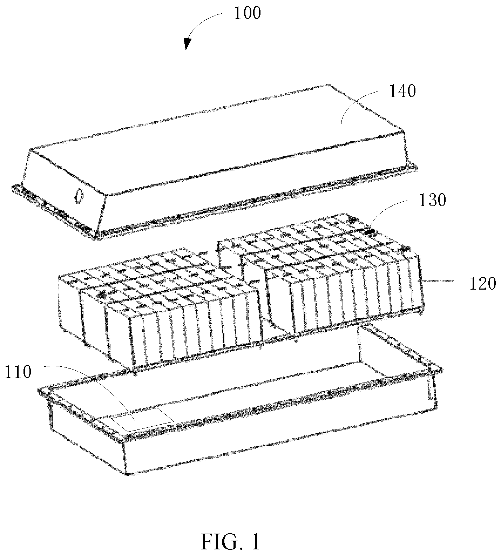

As shown in FIG. 1, a battery 100 according to an embodiment of this application may include: a battery management unit 110, a plurality of battery cells 120, and a cell monitoring unit 130 mounted on each battery cell 120 (only a part of the cell monitoring units are shown in the drawing). In actual use scenarios, a cell monitoring unit 130 may be disposed on each battery cell 120.

The battery management unit 110 records chip identification information of each battery cell 120 and location information of each battery cell. Optionally, the location identifier may be presented in the form of coordinates or in the form of values.

For example, the location identifier may be represented by coordinates, and the coordinates may indicate the row and column at which the battery cell 120 is located in the battery. For another example, the location identifier may be represented by a value, and the value may indicate the specific position at which the battery cell is located in a preset sequence.

The cell monitoring unit 130 stores the chip identification information of each battery cell 120 and the location information of each battery cell. When the battery management unit 110 needs to obtain the operating parameters of each battery cell 120, the battery management unit may communicate with each cell monitoring unit 130 to obtain the operating parameters of the battery cell 120 collected by each cell monitoring unit 130. The operating parameters may be parameters such as the operating temperature, voltage, and current of the battery cell 120.

Optionally, the cell monitoring unit 130 may write the location identifier of the battery cell 120 consistent with the chip identification information of the cell monitoring unit into a memory of the cell monitoring unit. The location identifier stored in the memory may be protected. This memory may be a type of microcontroller memory (One Time Programmable, OTP), a read-only memory (Read-Only Memory, ROM), a flash memory (Flash EEPROM), or the like.

Optionally, the battery of this embodiment may include a plurality of battery modules. Each battery module may include a plurality of battery cells 120.

A module identifier is set for each battery module. The module identifier keeps a record of the chip identification information of each battery cell 120 in the battery module and first location information of each battery cell 120 in the battery module.

The battery management unit 110 records second location information of each battery module in the battery.

As an example, the second location information may be just a numerical value. For example, the numerical value may represent the position number of the corresponding battery module in the battery. For example, if a battery includes five battery modules, the numerical value of the second location information may be any value from 1 to 5.

The first location information may be a numerical value, or a pair of numerical values, or a coordinate.

For example, the first location information is a numerical value, and the numerical value is used as a position number of the battery cell 120 in the battery module. For example, when the battery module includes seven rows and eight columns of battery cells 120, the value may be any value from 1 to 56.

For another example, a pair of numerical values may include a first numerical value and a second numerical value. The first numerical value is used as a position number of the battery module containing the battery cell 120 in the battery. For example, when a battery includes three battery modules, the first numerical value may be any value from 1 to 3. The second numerical value is used as a position number of the battery cell 120 in the battery module. For example, if the battery module includes seven rows and eight columns of battery cells 120, the second numerical value may be any value from 1 to 56.

In an example, the position numbers of the battery cells in the battery 100 may be arranged sequentially in the direction indicated by the dashed arrows shown in FIG. 1.

For another example, the coordinates may include a battery module position number and a battery cell 120 position number. The battery module position number represents the position number of the battery module containing the battery cell 120 in the battery. The battery cell 120 position number represents the position number of the battery cell 120 in the battery module.

The battery management unit 110 in the battery in this embodiment may further include a radio management unit and a host MCU (not shown in the drawing).

The radio management unit may be configured to manage the entire wireless network, communicate with the cell monitoring units 130 of all battery cells 120, receive voltage, temperature, current, and other parameters of the battery cells 120 collected by all cell monitoring units 130, and send a corresponding control instruction to the host MCU.

The host MCU is configured to control the communication between the radio management unit and the cell monitoring unit 130, implement data processing and analysis, and output a control instruction.

As shown in FIG. 1, the battery 100 may be a battery pack. The battery pack may further include a box 140. The battery cell 120 may be mounted in the box 140.

Alternatively, the battery 100 may be a battery module. The battery module includes a plurality of battery cells. The battery cells may be arranged as required.

An embodiment of this application provides an electrical device powered by a battery. The electrical device may be, but is not limited to, a mobile phone, a tablet, a laptop computer, an electric toy, an electric tool, an electric power cart, an electric vehicle, a ship, a spacecraft, or the like. The electric toy may include stationary or mobile electric toys, such as game console, electric car toy, electric ship toy, electric airplane toy, and the like. The spacecraft may include airplane, rocket, space shuttle, spaceship, and the like.

The battery encoding method may be implemented in the battery so that the battery management unit of the battery can store the information on each battery cell, thereby facilitating the communication between the battery management unit and the cell monitoring unit of each battery cell. To facilitate the understanding of this embodiment, first of all, the following describes an operating environment of a battery encoding method disclosed herein.

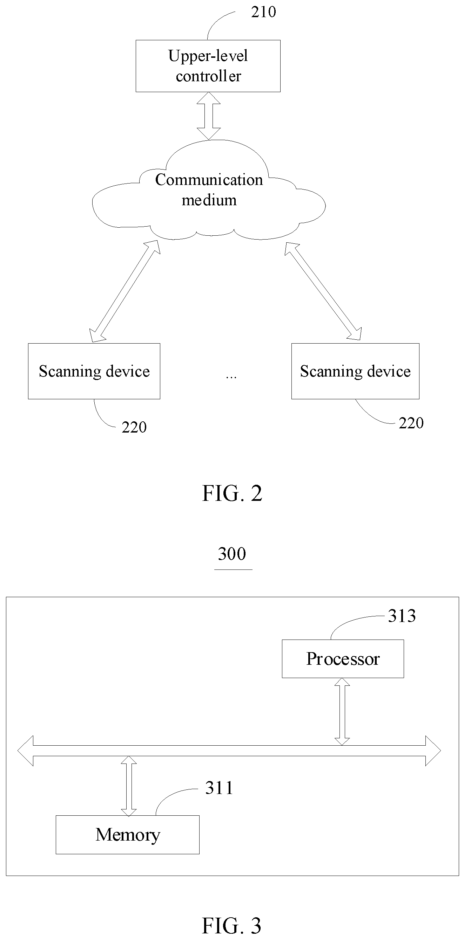

As shown in FIG. 2, which is a schematic diagram of interaction between an upper-level controller 210 and a scanning device 220 according to an embodiment of this application, the upper-level controller 210 is communicatively connected to one or more scanning devices 220 by a radio network or wires to implement data communication or interaction. The upper-level controller 210 may be a network server, a database server, or the like, or may be a personal computer (personal computer, PC), a tablet computer, a smartphone, a personal digital assistant (personal digital assistant, PDA), or the like.

As an example, the upper-level controller 210 and the scanning device 220 may be arranged in a battery shopfloor. The upper-level controller 210 may be configured to send a control instruction to each device in the shopfloor. The upper-level controller 210 can obtain operating parameters of devices in the shopfloor.

In this embodiment, the scanning devices 220 may be arranged at different locations in the shopfloor, so as to scan the identifiers on the battery cells or battery modules at different production stages of the battery. The identifier may be in the form of a string, a quick-response QR code, a barcode, or the like.

In an example, each identifier may be a QR code, and the scanning device 220 may be a QR code scanner.

In this embodiment, the upper-level controller 210 may be an electronic device that serves a storage function and a processing function. As shown in FIG. 3, which is a schematic block diagram of an electronic device, the electronic device 300 may include a memory 311 and a processor 313. A person of ordinary skill in the art understands that the structure shown in FIG. 3 is merely illustrative, but without limiting the structure of the electronic device 300. For example, the electronic device 300 may include more or fewer components than those shown in FIG. 3, or may be configured differently from FIG. 3.

The components such as the memory 311 and the processor 313 are electrically connected to each other directly or indirectly to transmit or exchange data. For example, such components may be electrically connected to each other by one or more communication buses or signal wires. The processor 313 is configured to execute an executable module stored in the memory.

The memory 311 may be, but is not limited to, a random access memory (Random Access Memory, RAM), a read-only memory (Read Only Memory, ROM), a programmable read-only memory (Programmable Read-Only Memory, PROM), an erasable programmable read-only memory (Erasable Programmable Read-Only Memory, EPROM), an electric erasable programmable read-only memory (Electric Erasable Programmable Read-Only Memory, EEPROM), or the like. The memory 311 is configured to store a program. The processor 313 executes the program upon receiving an execution instruction. The method performed by the electronic device 300 and defined in a process disclosed in any embodiment of this application is applicable to the processor 313, or can be implemented by the processor 313.

The processor 313 may be an integrated circuit chip capable of processing signals. The processor 313 may be a general-purpose processor, such as a central processing unit (Central Processing Unit, CPU for short) or a network processor (Network Processor, NP for short); and may be a digital signal processor (digital signal processor, DSP for short), an application-specific integrated circuit (Application Specific Integrated Circuit, ASIC for short), a field programmable gate array (FPGA) or another programmable logical device, a discrete gate or a transistor logical device, or a discrete hardware component. The processor can implement or perform the methods, steps, and logic block diagrams disclosed in an embodiment of this application. The general-purpose processor may be a microprocessor, or the processor may be any conventional processor or the like.

The electronic device 300 in this embodiment may be configured to execute the steps in each method according an embodiment of this application. An implementation process of the battery encoding method is described below with reference to several embodiments.

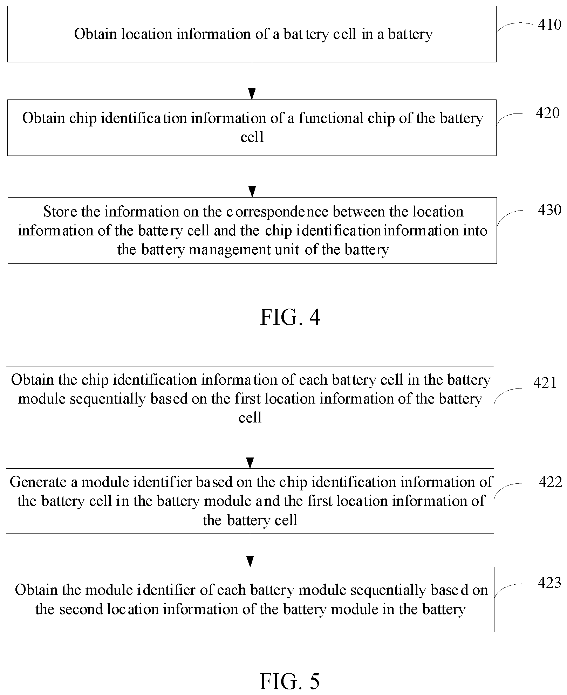

Referring to FIG. 4, which is a flowchart of a battery encoding method according to an embodiment of this application, the battery encoding method of this embodiment may be performed by the upper-level controller shown in FIG. 2, or by a system containing an upper-level controller and a scanning device. The specific process shown in FIG. 4 is described in detail below.

Step 410: Obtain location information of a battery cell in a battery.

Optionally, a starting position of the battery may be determined first. The starting position may be a battery cell at the outermost edge of the battery. For example, if the battery includes M rows and N columns of battery cells, the starting position may be the position of the battery cell in the first row and the first column. Next, from the starting position, the location information of each battery cell in the battery is determined sequentially based on the arrangement manner of the battery cells in the battery.

As an example, the battery may be identified by means of image recognition to determine the starting position of the battery.

As an example, the location information of the battery cell may be coordinates. For example, the coordinates represent the row number and column number of the battery cell in the battery. For example, if a battery cell is located in the m1^{th} row and the n1^{th} column in the battery, the location information of the battery cell may be (m1, n1).

As an example, the location information of the battery cell may be a numerical value, or a key character plus a numerical value. For example, if a battery includes a plurality of battery cells, the location information of the battery cell in the battery may be represented by a numerical value. For example, if a battery cell in a battery is arranged at position 10 in the example shown in FIG. 1, the location information of the battery cell may be 10. The location information may represent the position of each battery cell in the battery by using one or more numerical values and key characters. For example, if a battery cell in a battery is arranged at position 10 in the example shown in FIG. 1, the location information of the battery cell may be P10, where P is a position mark, and 10 is the position number of the battery cell.

As an example, the location information of the battery cell may be a plurality of numerical values, or a key character plus a numerical value. In an example in which a battery includes a plurality of battery modules and each battery module includes a plurality of battery cells, the location information may include a plurality of numerical values that indicate the positions of different battery cells in the battery. For example, if a battery cell is located in the 3^{rd} battery module, and the position number of the battery cell in the 3^{rd} battery module is 7, then the location information of the battery cell may be 3-7. This location information may represent the position of each battery cell in the battery by using a plurality of numerical values and key characters. For example, if a battery cell is located in the 3^{rd} battery module, and the position number of the battery cell in the 3^{rd} battery module is 7, then the correspondence information of the battery cell may be M3-7, where M is a battery module mark, 3 is the position number of the battery module in the battery, and 7 is the position number of the battery cell in the battery module.

Step 420: Obtain chip identification information of a functional chip of the battery cell.

The functional chip is a chip mounted on the battery cell and configured to monitor the battery cell and collect the operating parameters of the battery cell. For example, the functional chip may be a cell monitoring unit. The chip identification information may be a unique identifier of the cell monitoring unit of each battery cell. The chip identification information may be an identifier such as a QR code, a barcode, a character string that can uniquely represent the cell monitoring unit. The chip identification information may be sent along with the data of the cell monitoring unit. In other words, each frame of data sent by the cell monitoring unit may carry the chip identification information of the cell monitoring unit.

As an example, if the battery includes multiple rows and multiple columns of battery cells, the chip identification information of each battery cell in the battery may be obtained sequentially by starting from the first row and the first column. In an example in which one battery includes M rows and N columns of battery cells, the chip identification information of the battery cells in the first row may be obtained sequentially by starting from the first row and the first column until the chip identification information of the battery cell in the first row and the N^{th} column is obtained. Subsequently, in the second row, the chip identification information of the battery cells in the second row may be obtained sequentially by starting from the second row and the N^{th} column until the chip identification information of the battery cell in the second row and the first column is obtained. Subsequently, the chip identification information of the battery cells in the third row may be obtained sequentially by starting from the third row and the first column, and so on, thereby obtaining the chip identification information of each battery cell in the entire battery.

Alternatively, the chip identification information of the battery cells in each row may be obtained by starting from the first column uniformly.

As an example, if the battery includes a plurality of battery modules, and each battery module includes a plurality of rows and columns of battery cells, the chip identification information of all battery cells in each battery module may be obtained sequentially based on the sequence of the battery modules. For each battery module, the chip identification information of each battery cell in each battery module may be obtained sequentially. For example, the chip identification information of each battery cell in the battery may be obtained sequentially by starting from the first row and the first column. In an example in which the first battery module includes M1 rows and N1 columns of battery cells, the chip identification information of the battery cells in the first row may be obtained sequentially by starting from the first row and the first column until the chip identification information of the battery cell in the first row and the N1^{th} column is obtained. Subsequently, in the second row, the chip identification information of the battery cells in the second row may be obtained sequentially by starting from the second row and the N1^{th} column until the chip identification information of the battery cell in the second row and the first column is obtained. Subsequently, the chip identification information of the battery cells in the third row may be obtained sequentially by starting from the third row and the first column, and so on, thereby obtaining the chip identification information of each battery cell in the entire battery.

Optionally, step 410 and step 420 above may be performed alternately. For example, after the location information of each battery cell is obtained, the chip identification information of the functional chip of this battery cell may be obtained. Therefore, each time the location information and chip identification information of the battery cell are obtained, the two pieces of information are associated with each other.

Optionally, after the location information of all battery cells in the battery is obtained in step 410, the chip identification information of the functional chip of each battery cell is obtained. Subsequently, the information on the correspondence between the location information and the chip identification information may be created based on the relationship between each piece of location information and the chip identification information.

Optionally, the sequence between step 410 and step 420 may be different from the example shown in FIG. 4. For example, in obtaining the chip identification information of each battery cell, each piece of chip identification information may be stored sequentially in the order of being obtained, and then the location information of each battery cell is determined based on the storage order of each piece of chip identification information. For example, if the battery includes 96 battery cells, the 96 pieces of chip identification information may be stored sequentially to form an ordered array. For example, if a piece of chip identification information is stored at position 37, it means that the battery cell corresponding to the chip identification information is located at position 37 in the battery, and the location information of the battery cell may be expressed as 37 or P37, or the like.

Step 430: Store the information on the correspondence between the location information of the battery cell and the chip identification information into the battery management unit of the battery.

The chip identification information may be configured to implement a function of communication between the battery management unit and the functional chip of the battery cell. For example, when the battery management unit needs to communicate with each functional chip, the communication between the battery management unit and the functional chip may be implemented based on the identification information.

The correspondence information is used for indicating the location of the battery cell in the battery and the chip identification information of each battery cell. For example, the correspondence information may include the chip identification information and the location information of each battery cell.

Optionally, after the chip identification information of each battery cell in the battery is obtained, the chip identification information may be stored in the order of being obtained. When the chip identification information is needed, the relationship between each piece of chip identification information and the location information of each battery cell may be determined based on the storage sequence, so as to create the information on the correspondence between the location information of the battery cell and the chip identification information of the battery cell.

Optionally, the information on the correspondence may be formed by combining the location information of each battery cell with the chip identification information. For example, if a battery cell in a battery is arranged at position 13 in the example shown in FIG. 1, and the chip identification information of the battery cell is ID13, then the information on the correspondence may be expressed as 13_ID13 or P13_ID13.

For another example, if a battery cell is located in the 1^{st} battery module, and the position number of the battery cell in the 1^{st} battery module is 5, and the chip identification information of the battery cell is ID15, then the information on the correspondence of the battery cell may be expressed as 1-5_ID15 or M1-5_ID15.

Optionally, the location information of a battery cell may be bound to the chip identification information of the battery cell, so as to determine the information on the correspondence of one of the battery cells. For example, if the location information of a battery cell is P37, and the chip identification information of the battery cell is ID37, then the information on the correspondence of the battery cell may include P37 and ID37. In the correspondence information stored in the battery management unit, the chip identification information of the battery cell can be found to be ID37 based on P37. In the correspondence information stored in the battery management unit, the location information of the battery cell can be found to be P37 based on the chip identification information ID37.

Optionally, after the battery management unit obtains the correspondence information, the correspondence information may be sent to the cell monitoring unit corresponding to each battery cell, so that each cell monitoring unit also stores the correspondence information. For example, if the battery management unit of the battery is damaged and needs to be replaced with a new battery management unit, the correspondence information of each battery cell may be obtained from each cell monitoring unit first before the new battery management unit is put into use. For another example, if the battery management unit of the battery is damaged and the correspondence information recorded in the battery management unit is lost, each cell monitoring unit may send the correspondence information of each battery cell to the battery management unit first before the new battery management unit is put into use, so that the battery management unit stores the correspondence information.

In this embodiment, by storing the chip identification information of each battery cell in the battery management unit, the battery management unit is enabled to accurately learn the cell monitoring unit contained in the battery managed by the battery management unit, and therefore, is enabled to communicate with the cell monitoring unit contained, thereby more accurately obtaining the operating parameters of each battery cell contained.

In an optional embodiment, step 410 may include: obtaining the location information of the battery cell in the battery based on a preset sequence.

As an example, the location information of the battery cells in the battery may be obtained sequentially in the order indicated by the dashed arrows shown in FIG. 1.

Before the chip identification information of the functional chip of the battery cell is obtained, the location information of the battery cell may be obtained based on the sequence indicated by the dashed arrows. After the location information of the battery cell is obtained, the chip identification information of the functional chip of the battery cell is obtained. Step 410 and step 420 may be performed repeatedly in the order indicated by the dashed arrows shown in FIG. 1, so as to complete obtaining the location information of the battery cell in the battery and obtaining the chip identification information.

In an optional embodiment, step 410 may include: obtaining the chip identification information of the functional chip of the battery cell based on the location information of the battery cell.

Optionally, after the location information of any one battery cell is determined, the chip identification information of this battery cell is obtained promptly.

Optionally, the position of each battery cell may be determined based on the location information of the battery cell, so as to read the chip identification information of the functional chip of the battery cell at this position. As an example, after the chip identification information is obtained, the chip identification information may be associated with the location information of the battery cell.

The battery provided in this embodiment may include a plurality of battery modules. Each battery module includes a plurality of battery cells. On this basis, as shown in FIG. 5, step 420 may include step 421 to step 423.

Step 421: Obtain the chip identification information of each battery cell in the battery module sequentially based on the first location information of the battery cell.

In an embodiment, the chip identification information of each battery cell in the battery module is scanned sequentially based on the first location information of the battery cell by use of a scanning device after the battery module is assembled.

For example, if a battery module includes M1 rows and N1 columns of battery cells, then the first location information of each battery cell in the battery module may be determined sequentially in an order from the first row to the M1^{th} row, and in each row, from the first column to the N1^{th} column. Therefore, the chip identification information of the M1×N1 battery cells in the battery module may be scanned sequentially by the scanning device in the order from the first row to the M1^{th} row, and in each row, from the first column to the N1^{th} column.

For example, the chip identification information of each battery cell may be marked on the cell monitoring unit of the battery cell. For example, the chip identification information may be engraved on the surface of the cell monitoring unit to facilitate the scanning device to scan the chip identification information.

In another embodiment, the first location information of the battery cell may be determined sequentially based on the assembling sequence of the battery cells in a process of assembling the battery module. In this case, the chip identification information of each battery cell used for assembling the battery module may be obtained sequentially based on the assembling sequence of each battery cell.

As an example, in assembling the battery module, the first location information of each battery cell in the assembled battery module may be determined, and the chip identification information of each battery cell may be collected.

In another embodiment, the chip identification information of each battery cell used for assembling the battery module is obtained sequentially based on the first location information of the battery cell after the battery module is assembled.

For example, after each battery module is assembled, the first location information of each battery cell in the battery module may be determined sequentially based on the preset sequence, and the chip identification information of the battery cells in the battery module is also scanned sequentially based on the first location information of each battery cell. The preset sequence may be the first row to the M1^{th} row. In each row, the battery cells may be scanned sequentially from the first column to the N1^{th} column, or may be scanned in a serpentine order. For example, the odd rows may be scanned sequentially from the first column to the N1^{th} column, and the even rows may be scanned sequentially from the N1^{th} column to the first column.

Step 422: Generate a module identifier based on the chip identification information of the battery cell in the battery module and the first location information of the battery cell.

The module identifier includes chip identification information and location information of the battery cells contained in the battery module.

As an example, the module identifier may include the chip identification information of all battery cells contained in the battery module and the location information of each battery cell in the battery module. For example, the location information of the i^{th} battery cell in a battery module may be Mx-i, where x represents a position to be determined. After the position of the battery module in the battery is determined, the position to be determined can be determined. For example, if the battery module is mounted at the fourth position in the entire battery, the value of x may be 4.

Step 423: Obtain the module identifier of each battery module sequentially based on the second location information of the battery module in the battery.

Optionally, the module identifier of each battery module is scanned by the scanning device sequentially based on the position of each battery module in the battery after the battery modules are assembled to form the battery.

For example, if the battery module is arranged at the j^{th} position in the battery, the location information of the i^{th} battery cell in the battery module may be Mj-i.

The correspondence information may include the first location information that represents the position of each battery cell in the battery module, the second location information that represents the position of the battery module containing the battery cell in the battery, and the chip identification information of the functional chip of the battery cell.

The correspondence information may include the relationship between the location information of each battery cell and the chip identification information. The association information of each battery cell may be represented by a string of characters, or may be presented by binding the location information and the chip identification information together.

If the battery module is arranged at the j^{th} position in the battery, the location information of the i^{th} battery cell in the battery module may be Mj-i, and the chip identification information of the battery cell may be IDji. In an example, the association information of a battery cell is represented by a string of characters, and the association information of the battery cell may be Mj-i_IDji. In another example, just the location information Mj-i and the chip identification information IDji are bound and stored in the battery management unit. The battery management unit can find the chip identification information of the battery cell to be IDji based on the position information Mj-i. The battery management unit can also find the location information of the battery cell to be Mj-i based on the chip identification information IDji of the battery cell.

Further, step 430 may include: determining the information on the correspondence between the location information of the battery cell and the chip identification information based on the second location information and the module identifier; and storing the information on the correspondence between the location information of the battery cell and the chip identification information into the battery management unit of the battery, where the battery management unit communicates with the functional chip based on the identification information.

In this embodiment, if the battery includes a plurality of battery modules, an intermediate identifier, that is, a module identifier, may be formed first, thereby reducing the complexity of the location information, making the relative position of each battery cell clearer, and in turn, improving the accuracy of the location relation between the battery cells conveyed by the correspondence information.

Corresponding to each battery cell, not only the uniquely corresponding chip identification information of the cell monitoring unit contained in the battery cell exists, but also cell identification information exists and is used for recording the battery cell production information and battery cell characteristic information. Therefore, the cell identification information may also be included in the correspondence information stored in the battery management unit. Before step 410, the battery encoding method may further include: obtaining the cell identification information and the chip identification information of each battery cell after each battery cell is manufactured, and storing the cell identification information in association with the chip identification information of each battery cell.

Step 430 may include: storing the information on the correspondence between the location information of the battery cell, the chip identification information, and the cell identification information into the battery management unit of the battery.

Each cell monitoring unit is bound to the battery cell during the production of the battery cell. After each battery cell is taken off the production line, the chip identification information may be used as the identifier of the battery cell.

Optionally, when the cell monitoring unit is fitted onto the battery cell to implement physical binding between the cell monitoring unit and the battery cell, the cell identification information and the chip identification information may be scanned by a scanning device, and the cell identification information is bound to the chip identification information.

Therefore, when the cell identification information of any one battery cell is obtained, the chip identification information of the battery cell can be determined based on the pre-associated stored data; when the chip identification information of any one battery cell is obtained, the cell identification information of the battery cell can be determined based on the pre-associated stored data.

In an example, the battery module is arranged at the j^{th} position in the battery. In this case, the location information of the i^{th} battery cell in the battery module may be Mj-i, the chip identification information of the battery cell may be IDji, and the cell identification information of the battery cell may be ID-ji. In an example, the association information of a battery cell is represented by a string of characters, and the association information of the battery cell may be Mj-i_IDji_ID-ji.

In another example, the chip identification information of the battery cell with the location information P37 may be ID37, and the cell identification information of the battery cell may be ID-37. In this case, the correspondence information of the battery cell may be expressed as P37_ID37_ID-37.

The implementation process of the above battery encoding method implements a networking process during initial assembling of a battery. To be specific, when the battery management unit sends information, the battery management unit communicates with only the cell monitoring units that have chip identification information already existent in a storage list of the battery management unit, but does not communicate with the cell monitoring units that have the chip identification information absent in the storage list, thereby preventing the battery from communicating with the cell monitoring units of other batteries or the cell monitoring unit of the battery cell to be assembled.

The advantage of the above encoding method is that the battery management unit in each battery stores the chip identification information of the cell monitoring unit with which the battery management unit needs to communicate. Subsequently, an abnormal battery cell can be quickly located based on the chip identification information and the corresponding location information.

During the above battery application, the battery management unit communicates with only the cell monitoring unit with chip identification information existent in the storage list of the battery management unit. This is equivalent to identity authentication, and improves the reliability of data communication and prevents hackers from affecting communication and stealing data subsequently by using fake cell monitoring unit information (requiring a decoding process additionally). In addition, each cell monitoring unit stores its own location identifier and provides a backup. In a case that the battery management unit is abnormal and loses the storage list of the chip identification information of the cell monitoring unit, a new battery management unit can be used instead to read the data back from each cell monitoring unit, thereby avoiding the need of re-scanning for confirmation.

The following describes a process of the battery encoding method by using two examples.

If battery cells are directly assembled to form a battery, the battery may be encoded by the following process:
A cell monitoring chip on each cell monitoring unit needs to have its own unique chip identification information. The unique chip identification information can be sent along with the data of the cell monitoring unit (that is, each frame of data sent by the cell monitoring unit carries the chip identification information). The unique chip identification information may be marked in the form of a QR code on the chip casing of the cell monitoring unit of the battery cell.

A process of binding the cell monitoring unit to a battery cell: After being taken off the production line, each battery cell has its own unique cell identification information. The cell identification information may be a QR code. To fit the cell monitoring unit onto the battery cell, the QR code of the battery cell and the QR code of the chip are scanned by a scanning device to implement software binding between the cell monitoring unit and the battery cell. In addition, the chip of the cell monitoring unit is integrated into the battery cell to implement physical binding. Therefore, the unique chip identification information of the cell monitoring unit may be used as the identifier of the entire battery cell.

After the battery cells are assembled to form a battery, the QR code of each battery cell in the battery is scanned sequentially by using a scanning device. For example, the scanning may start with BAT- as the first one.

Through the above operation flow, a correspondence is obtained, for example, P1_ID1_ID-1. For the 1^{st} battery cell of the battery, the chip identification information of the corresponding cell monitoring unit is ID1, and the cell identification information of the corresponding battery cell is ID-1.

Therefore, based on the chip identification information carried in the data sent by each battery cell, the physical location of the battery cell in the battery can be determined.

If the battery cells need to be assembled to form a battery module and then the battery modules are assembled to form a battery, the battery may be encoded by the following process:

A process of binding the cell monitoring unit to a battery cell: After being taken off the production line, each battery cell has its own unique cell identification information. The cell identification information may be a QR code. To fit the cell monitoring unit onto the battery cell, the QR code of the battery cell and the QR code of the chip are scanned by a scanning device to implement software binding between the cell monitoring unit and the battery cell. In addition, the chip of the cell monitoring unit is integrated into the battery cell to implement physical binding. Therefore, the unique chip identification information of the cell monitoring unit may be used as the identifier of the entire battery cell.

After the battery cells are assembled to form a battery module, the QR code information of the cell monitoring units is scanned one by one by a scanning device in sequence from the negative terminal to positive terminal in the battery module, and then a module QR code is generated. The QR code needs to contain the order of the chip identification information of the cell monitoring unit. For example, in Mx-1, Mx-2, x is a reserved position, and may be filled with a symbol that specifically represents the order of the battery module, such as 1, 2, I, or II.

After the battery modules are assembled to form a battery, the QR code of each battery module is scanned sequentially by using a scanning device (generally, the scanning starts with BAT- as the first one). The ordinal information of the battery module is written into the reserved position to form M1-1, M1-2, M2-2, and the like. In this way, the ordinal information of the battery module and the ordinal information of the battery cell in the battery module are formed, and bound to each other.

In this way, the correspondence such as M1-1_ID1_ID-1 is obtained, and identifies the first battery cell of the battery module 1. The ID of the corresponding cell monitoring unit is ID1, and the ID of the corresponding battery cell is ID-1.

Subsequently, after completing the above process, the upper-level controller may send the corresponding information to the battery management unit of the battery. The battery management unit stores the data in the memory, and sends the data to each cell monitoring unit through a radio management unit. The cell monitoring unit writes the location information consistent with its own chip identification information into its own memory. The storage location of the location information is protected.

At the same time, this process also implements a networking process during initial assembling of the battery. To be specific, when the battery management unit sends information, the battery management unit communicates with only the cell monitoring units that have chip identification information already existent in a storage list of the battery management unit, but does not communicate with the cell monitoring units that have the chip identification information absent in the storage list, thereby preventing the battery from communicating with other batteries or the battery cell to be assembled, and improving effectiveness of the work of the battery management unit.

Based on the same concept, an embodiment of this application further provides a battery encoding apparatus corresponding to the battery encoding method. Because the principles of solving the problems by the apparatus according to this embodiment of this application are similar to those described in the embodiment of the battery encoding method above, the implementation of the apparatus in this embodiment may be learned by reference to the description in the above method embodiment, details of which are omitted here.

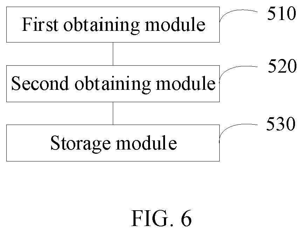

Referring to FIG. 6, which is a schematic diagram of functional modules of a battery encoding apparatus according to an embodiment of this application, each module in the battery encoding apparatus in this embodiment is configured to execute the corresponding steps in the above method embodiment. The battery encoding apparatus includes: a first obtaining module 510, a second obtaining module 520, and a storage module 530. The modules are described below:

The first obtaining module 510 is configured to obtain location information of a battery cell in a battery.

The second obtaining module 520 is configured to obtain chip identification information of a functional chip of the battery cell.

The storage module 530 is configured to store information on a correspondence between the location information of the battery cell and the chip identification information into a battery management unit of the battery, where the chip identification information is used for implementing a communication function between the battery management unit and the functional chip of the battery cell.

In a possible embodiment, the first obtaining module 510 is configured to obtain location information of a battery cell in a battery based on a preset sequence.

In a possible embodiment, the second obtaining module 520 is configured to obtain the chip identification information of the functional chip of the battery cell based on the location information of the battery cell.

In a possible embodiment, the battery includes a plurality of battery modules. Each battery module includes a plurality of battery cells. The location information of the battery cell includes second location information and first location information. The second location information is location information that indicates a location of the battery module containing the battery cell in the battery, and the first location information is location information that indicates a location of the battery cell in the battery module.

The second obtaining module 520 is configured to obtain the chip identification information of each battery cell in the battery module sequentially based on the first location information of the battery cell; generate a module identifier based on the chip identification information of the battery cell in the battery module and the first location information of the battery cell; and obtain the module identifier of each battery module sequentially based on the second location information of the battery module in the battery.

The storage module 530 is configured to determine the information on the correspondence between the location information of the battery cell and the chip identification information based on the second location information and the module identifier; and store the information on the correspondence between the location information of the battery cell and the chip identification information into the battery management unit of the battery, where the battery management unit communicates with the functional chip based on the identification information.

In a possible embodiment, the second obtaining module 520 is further configured to: scan the chip identification information of each battery cell in the battery module sequentially based on the first location information of the battery cell by use of a scanning device after the battery module is assembled; and scan the module identifier of each battery module sequentially based on the second location information of the battery module in the battery by use of the scanning device after the battery modules are assembled to form the battery.

In a possible embodiment, the first obtaining module 510 is configured to obtain the first location information of the battery cell in the battery module sequentially based on an arrangement manner of the battery cell in the battery module after the battery module is assembled; and obtain the second location information of the battery module in the battery sequentially based on an arrangement manner of the battery module in the battery after the battery is assembled.

In a possible embodiment, the information on the correspondence further includes cell identification information.

The battery encoding apparatus according to this embodiment may further include: an association module, configured to obtain the cell identification information and the chip identification information of each battery cell after each battery cell is manufactured, and store the cell identification information in association with the chip identification information of each battery cell; and

a storage module 530, configured to store the information on the correspondence between the location information of the battery cell, the chip identification information, and the cell identification information into the battery management unit of the battery.

In addition, an embodiment of this application further provides a computer-readable storage medium. The computer-readable storage medium stores a computer program. When executed by a processor, the computer program performs steps of the battery encoding method described in the above method embodiment.

The computer program product of the battery encoding method according to an embodiment of this application includes a computer-readable storage medium that stores program code. Instructions included in the program code may be used for performing steps of the battery encoding method in the above method embodiment. For details, reference may be made to the above method embodiment, and the details are not repeated here.

In the several embodiments provided in this application, it is to be understood that the disclosed apparatus and method may be implemented in other manners instead. The device embodiments described above are merely illustrative. For example, the flowcharts and block diagrams in the accompanying drawings show the system architecture, functions, and operations that may be implemented by the device, method, and computer program product according to some embodiments of this application. In this regard, each block in a flowchart or block diagram may represent a module, program segment, or part of code. The module, program segment, or part of code includes one or more executable instructions that are used for implementing specified logic functions. It is also worth noting that, in some alternative implementations, the functions noted in the block may occur in order different from the order specified in the drawings. For example, two consecutive blocks may practically be executed almost in parallel, or may sometimes be executed in reverse order, depending upon the functionality involved. It is also worth noting that each block in the block diagrams and/or flowcharts, and a combination of the blocks in the block diagrams and/or flowcharts, may be implemented by a dedicated hardware-based system that performs the specified functions or actions, or may be implemented by a combination of dedicated hardware and computer instructions.

In addition, function modules in each embodiment of this application may be integrated together to form a stand-alone part, or each module may exist alone, or two or more modules may be integrated into a stand-alone part.

When the functions are implemented in the form of a software functional module and sold or used as an independent product, the functions may be stored in a computer-readable storage medium. Based on such an understanding, the essence of the technical solution of this application, or the part making contributions to the prior art, or a part of the technical solution may be embodied in the form of a software product. The computer software product is stored in a storage medium, and includes several instructions for instructing a computer device (such as a personal computer, a server, a network device) to perform all or part of the steps of the method described in each embodiment of this application. The storage medium includes any medium that can store program code, such as a USB flash disk, a removable hard disk, a read-only memory (ROM, Read-Only Memory), a random access memory (RAM, Random Access Memory), a magnetic disk, or an optical disk. It is hereby noted that the relational terms herein such as first and second are used only to differentiate one entity or operation from another, but do not require or imply any actual relationship or sequence between the entities or operations. Moreover, the terms "include", "comprise", and any variation thereof are intended to cover a non-exclusive inclusion relationship by which a process, method, object, or device that includes or comprises a series of elements not only includes such elements, but also includes other elements not expressly specified or also includes inherent elements of the process, method, object, or device. Unless otherwise specified in the context, reference to a process, method, object, or device that "includes" or "comprises" a specific number of elements shall not exclude other equivalent elements existent in the process, method, object, or device.

What is described above is merely exemplary embodiments of this application, but is not intended to limit this application. To a person skilled in the art, various modifications and variations may be made to this application. Any and all modifications, equivalent replacements, improvements, and the like made without departing from the spirit and principles of this application still fall within the protection scope of this application. It is hereby noted that similar reference numerals and letters indicate similar items in the following drawings. Therefore, once an item is defined in one drawing, the item does not need to be further defined or construed in subsequent drawings.

Described above are merely specific embodiments of this application, and the protection scope of this application is not limited to such embodiments. Any and all variations or replacements easily conceivable by a person skilled in the art within the technical scope disclosed herein still fall within the protection scope of this application. Therefore, the protection scope of this application is subject to the protection scope of the claims.

## Claims

1. A battery encoding method, **characterized in that** the method comprises:
obtaining location information of a battery cell in a battery;
obtaining chip identification information of a functional chip of the battery cell; and
storing information on a correspondence between the location information of the battery cell and the chip identification information into a battery management unit of the battery, wherein the chip identification information is used for implementing a communication function between the battery management unit and the functional chip.

2. The method according to claim 1, **characterized in that** the obtaining location information of a battery cell in a battery comprises:
obtaining the location information of the battery cell in the battery based on a preset sequence.

3. The method according to claim 1, **characterized in that** the obtaining chip identification information of a functional chip of the battery cell comprises:
obtaining the chip identification information of the functional chip of the battery cell based on the location information of the battery cell.

4. The method according to claim 3, **characterized in that** the battery comprises a plurality of battery modules, each battery module comprises a plurality of battery cells, the location information of the battery cell comprises second location information and first location information, the second location information is location information that indicates a location of the battery module containing the battery cell in the battery, and the first location information is location information that indicates a location of the battery cell in the battery module;
the obtaining the chip identification information of the functional chip of the battery cell based on the location information of the battery cell comprises:
obtaining the chip identification information of each battery cell in the battery module sequentially based on the first location information of the battery cell;
generating a module identifier based on the chip identification information of the battery cell in the battery module and the first location information of the battery cell;
obtaining the module identifier of each battery module sequentially based on the second location information of the battery module in the battery; and
the storing information on a correspondence between the location information of the battery cell and the chip identification information into a battery management unit of the battery comprises:
determining the information on the correspondence between the location information of the battery cell and the chip identification information based on the second location information and the module identification; and
storing the information on the correspondence between the location information of the battery cell and the chip identification information into the battery management unit of the battery.

5. The method according to claim 4, **characterized in that** the obtaining the chip identification information of each battery cell in the battery module sequentially based on the first location information of the battery cell comprises:
scanning the chip identification information of each battery cell in the battery module sequentially based on the first location information of the battery cell by use of a scanning device after the battery module is assembled; and
the obtaining the module identifier of each battery module sequentially based on the second location information of the battery module in the battery comprises:
scanning the module identifier of each battery module sequentially based on the second location information of the battery module in the battery by use of the scanning device after the battery modules are assembled to form the battery.

6. The method according to claim 4, **characterized in that** the obtaining location information of a battery cell in a battery comprises:
obtaining the first location information of the battery cell in the battery module sequentially based on an arrangement manner of the battery cell in the battery module after the battery module is assembled; and
obtaining the second location information of the battery module in the battery sequentially based on an arrangement manner of the battery module in the battery after the battery is assembled.

7. The method according to any one of claims 1 to 6, **characterized in that** the information on the correspondence further comprises cell identification information;
the method further comprises: obtaining the cell identification information and the chip identification information of each battery cell after each battery cell is manufactured, and storing the cell identification information in association with the chip identification information of each battery cell; and
the storing information on a correspondence between the location information of the battery cell and the chip identification information into a battery management unit of the battery comprises:
storing information on a correspondence between the location information of the battery cell, the chip identification information, and the cell identification information into the battery management unit of the battery.

8. A battery encoding apparatus, **characterized in that** the apparatus comprises:
a first obtaining module, configured to obtain location information of a battery cell in a battery;
a second obtaining module, configured to obtain chip identification information of a functional chip of the battery cell; and
a storage module, configured to store information on a correspondence between the location information of the battery cell and the chip identification information into a battery management unit of the battery, wherein the chip identification information is used for implementing a communication function between the battery management unit and the functional chip.

9. An electronic device, **characterized in that** the electronic device comprises a processor and a memory; the memory stores a machine-readable instruction executable by the processor; and, when executed by the processor during operation of the electronic device, the machine-readable instruction performs steps of the method according to any one of claims 1 to 7.

10. A computer-readable storage medium, **characterized in that** the computer-readable storage medium stores a computer program, and, when executed by a processor, the computer program performs steps of the method according to any one of claims 1 to 7.

11. A battery, **characterized in that** the battery comprises: a battery management unit, a plurality of battery cells, and a cell monitoring unit mounted on each battery cell;
the battery management unit records chip identification information of each battery cell and location information of each battery cell; and
the cell monitoring unit stores the chip identification information of each battery cell and the location information of each battery cell.

12. The battery according to claim 11, **characterized in that** a plurality of battery cells form a plurality of battery modules;
a module identifier is set for each battery module;
the module identifier keeps a record of the chip identification information of each battery cell in the battery module and first location information of each battery cell in the battery module; and
the battery management unit records second location information of each battery module in the battery.

13. An electrical device, **characterized in that** the electrical device comprises the battery according to claim 11 or 12, and the battery is configured to provide electrical energy.
